# EUROPÄISCHE PATENTSCHRIFT

(11) **EP 1 144 976 B1**
(45) Veröffentlichungstag und Bekanntmachung des Hinweises auf die Patenterteilung: **06.11.2002**
(21) Anmeldenummer: 99948891.9
(22) Anmeldetag: 29.09.1999
(51) Int. Cl.: G01L 9/12, G01L 9/06

(54) **VERFAHREN ZUM ERZEUGEN EINER MIKROMECHANISCHEN STRUKTUR FÜR EIN MIKRO-ELEKTROMECHANISCHES ELEMENT**
METHOD OF PRODUCING A MICROMECHANICAL STRUCTURE FOR A MICRO-ELECTROMECHANICAL ELEMENT
PROCEDE POUR PRODUIRE UNE STRUCTURE MICROMECANIQUE POUR UN ELEMENT MICRO-ELECTROMECANIQUE

(30) Priorität: 15.12.1998 DE 19857741; 18.06.1999 DE 19927971
(43) Veröffentlichungstag der Anmeldung: 17.10.2001
(73) Patentinhaber: Fraunhofer-Gesellschaft zur Förderung der angewandten Forschung e.V., 80636 München (DE)
(72) Erfinder: SEITZ, Stefan, D-86949 Windach (DE); HÖFTER, Leonhard, D-80939 München (DE); KRUCKOW, Jürgen, D-80538 München (DE); NEUMEIER, Karl, D-82008 Unterhaching (DE); BOLLMANN, Dieter, D-81475 München (DE)
(74) Vertreter: Schoppe, Fritz, Dipl.-Ing.
(86) Internationale Anmeldenummer: EP9907206
(87) Internationale Veröffentlichungsnummer: WO00036385

(56) Entgegenhaltungen:
- EP-A- 0 610 806
- EP-A- 0 639 761
- EP-A- 0 702 221
- WO-A-96/18872
- US-A- 4 203 128
- US-A- 4 513 348
- US-A- 5 600 072
- US-A- 5 744 725
- L.J. SPANGLER ET AL.: "A BULK SILICON SOI PROCESS FOR ACTIVE INTEGRATED SENSORS" SENSORS AND ACTUATORS A., Bd. A24, Nr. 2, Juli 1990 (1990-07), Seiten 117-1221, XP000148921 ELSEVIER SEQUOIA S.A., LAUSANNE., CH ISSN: 0924-4247

## Beschreibung

Die vorliegende Erfindung bezieht sich auf ein Verfahren zum Erzeugen einer mikromechanischen Struktur für ein mikro-elektromechanisches Element, und insbesondere auf ein Verfahren zum Erzeugen einer membranartigen Struktur in einem Halbleiterwafer, in dem später unter Verwendung herkömmlichen Standard-Halbleiterprozesse eine integrierte Schaltung erzeugt werden soll.

Aufgrund der schnellen Entwicklung auf dem Gebiet der Halbleiterindustrie und der Mikroelektronik verdrängen mikromechanische Elemente, beispielsweise mikromechanische Druckmeßzellen auf Siliziumbasis, mehr und mehr klassische mechanische Druckwandler. Mikromechanische Elemente werden beispielsweise in der Automatisierungs- und Medizin-Technik, sowie in Kfz-Anwendungen in großen Mengen eingesetzt. Vorzugsweise werden dabei mikro-elektromechanische integrierte Systeme verwendet, die die Verbindung von mechanischen und elektronischen Funktionen auf einem Substrat realisieren. Neben den in CMOS- oder ähnlicher Technologie hergestellten elektronischen Bauelementen, bei denen es sich beispielsweise um Meßwandler, Verstärker, Speicher, Mikrocontroler, usw., handelt, befinden sich dabei in denselben Schichten mechanische Bauelemente. Diese können beispielsweise Membranen von Drucksensoren, elastische Platten von Ventilen oder Pumpen, schwingende Massen von Beschleunigungssensoren, bewegliche Finger oder einseitig eingespannte Arme von Schaltern und dergleichen sein. Über die von der Planartechnologie gewohnte mehr oder weniger glatte Oberfläche hinaus sind diese mechanischen Strukturen dreidimensional und umfassen freitragende Strukturen und vergrabene Hohlräume.

Es war bisher bekannt, solche Hohlräume durch naßchemisches Ätzen zu erzeugen, bzw. durch Verbinden zweier zuvor einzeln fertig bearbeiteter Scheiben. Als Verbindungstechnik zum Verbinden der einzeln bearbeiteten Scheiben kommen dabei ein Waferbonden (Silicon Fusion Bonding), ein anodisches Bonden oder ein Kleben in Frage. In jedem Fall sind bei herkömmlichen Verfahren vor dem Verbinden der einzelnen Scheiben dieselben vollständig bearbeitet, so daß danach keine Verarbeitungsschritte mehr stattfinden müssen, die zu einer Beeinträchtigung der mechanischen Strukturen führen können.

Beim naßchemischen Unterätzen von Strukturen tritt das Problem des sogenannten "Sticking" auf, bei dem die freitragende Struktur beim Trocknen der Flüssigkeit durch Kapillarkräfte an der benachbarten Oberflächen haften bleibt und somit ihre Beweglichkeit verliert. Kleine Gräben, Löcher und Spalten bereiten überdies Probleme beim Benetzen mit Flüssigkeiten (beispielsweise mit Ätzlösungen, Reinigungswasser, Photolack) und beim Entfernen der Flüssigkeiten, beispielsweise durch Blasen, die in Ecken haften bleiben können. Beim Abschleudern können Tropfen zurückbleiben, die beim Eintrocknen Ränder erzeugen. Auch die Reinigung durch Bürsten ist problematisch, da die beweglichen Strukturen dabei abgebrochen werden können. Andererseits ist jedoch eine reine Oberfläche der Strukturen notwendig, um die Herstellungsverfahren zum Erzeugen der Auswertestrukturen, wie z.B. ein CMOS-verfahren, anwenden zu können. Durch die Gefahr der Verschleppung von Partikeln und Kontaminationen kann bei offenen Strukturen die CMOS-Fähigkeit nicht mehr gegeben sein, d.h. bestimmte Prozeßabläufe sind in einer CMOS-Linie nicht erlaubt. Darüberhinaus wird beim Vereinzeln der Chips aus dem Waferverbund mit einer Wafersäge mit Wasser gespült, das in offene Hohlräume eindringen kann, und somit das Problem bezüglich Partikeln und Kontaminationen noch erschweren kann.

Überdies ist es bekannt, membranartige Strukturen durch die Verwendung eines KOH-Rückseitenätzens zu erzeugen, nachdem die elektronischen Komponenten auf der Vorderseite eines Wafers fertiggestellt sind. Durch die bei einer KOH-Ätzung auftretenden schrägen Ätzkanten tritt hier jedoch ein hoher Verlust an Integrationsdichte auf, insbesondere, wenn eine hohe Stückzahl mikro-elektromechanischer Komponenten aus einem Wafer gebildet wird.

Unterschiedliche Verfahren zum Herstellen von Halbleiterdruckfühlern sind ferner in der DE 3743080 A1 beschrieben.

In der DE-C-19543893 ist ein Verfahren zum Ausrichten von in einem Substrat zu erzeugenden Strukturen beschrieben, bei dem eine membranartige Struktur über einem Hohlraum gebildet wird. Zu diesem Zweck wird zunächst ein abgeschlossener Hohlraum zwischen zwei Substraten erzeugt, indem in einer Maskierungsschicht auf einem der Substrate eine Ausnehmung erzeugt wird, nachfolgend die beiden Substrate über die Maskierungsschicht verbunden werden und abschließend eines der Substrate gedünnt wird.

Aus der EP-A-639761 ist ein Verfahren zum Herstellen eines Differenzdrucksensors bekannt, bei dem eine Substratstruktur, in der ein mikromechanisches Element gebildet ist, mit einem Glassubstrat verbunden wird.

Aus der EP-A-702221 ist ein Verfahren zum Herstellen einer mikromechanischen Struktur und einer integrierten Schaltung in einem Baustein beschrieben, wobei zunächst die integrierte Schaltung unter Verwendung von CMOS-Prozessen erzeugt wird und nach der Erzeugung der integrierten Schaltung die mikromechanische Struktur bestehend aus Hohlraum und Membran implementiert wird.

Die Aufgabe der vorliegenden Erfindung besteht darin, ein Verfahren zum Erzeugen einer mikromechanischen Struktur und eines mikro-elektromechanischen Elements zu schaffen, die die Verwendung herkömmlicher Standard-Verfahren zum Erzeugen von Auswerteschaltungen in dem gleichen Substrat, in dem die mikromechanische Struktur gebildet ist, ermöglichen, wobei für die resultierenden mikro-elektromechanischen Elemente eine hohe Ausbeute erzielt werden kann und die mikromechanische Struktur flexibel einsetzbar ist.

Diese Aufgabe wird durch ein Verfahren zum Erzeugen einer mikromechanischen Struktur nach Anspruch 1 und ein mikro-elektromechanisches Element nach Anspruch 13 gelöst.

Bei der erfindungsgemäß erzeugten mikromechanischen Struktur, bei der der Hohlraum nach dem Dünnen von einem der Wafer weiterhin hermetisch abgeschlossen bleibt, kann nun eine integrierte Schaltung unter Verwendung herkömmlicher Standard-Halbleiterfertigungsprozesse in dem gedünnten Wafer integriert werden. Dabei bleibt der Hohlraum, der zusammen mit der membranartigen Struktur das mikromechanische Element definiert, stets hermetisch abgeschlossen, so daß die oben beschriebenen Probleme bei der Anwendung beispielsweise eines CMOS-Verfahrens zur Erzeugung einer integrierten Schaltung erfindungsgemäß nicht auftreten. Überdies entfallen aufgrund des hermetisch abgeschlossenen Hohlraums die vorher erwähnten Probleme des Beseitigens der Ätzflüssigkeiten aus den Hohlräumen, da aufgrund der hermetischen Abgeschlossenheit während der Herstellung der integrierten Schaltung keine Flüssigkeiten, Gase oder Feststoffe in den Hohlraum eindringen können. Folglich ermöglicht das erfindungsgemäße Verfahren zum Erzeugen einer mikromechanischen Struktur die Herstellung von mikro-elektromechanischen Elementen, beispielsweise Drucksensoren oder gesteuerten Ventilen, mit einer verringerten Anzahl von Bearbeitungsschritten, so daß die vorliegende Erfindung eine kostengünstige Herstellung ermöglicht.

Diese Vorteile werden erfindungsgemäß erreicht, indem ein hermetisch abgeschlossener Hohlraum in einer Zwischenschicht gebildet wird, die zum Verbinden zweier Halbleiterwafer verwendet wird. Bei bevorzugten Ausführungsbeispielen der Erfindung ist auf beiden Halbleiterwafern eine Zwischenschicht aufgebracht, von denen beide strukturiert werden, um nach dem Verbinden den Hohlraum zu bilden, wobei es sich bei den Zwischenschichten um isolierende oder leitende Schichten handelt, die beispielsweise aus Oxid (thermisch oder TEOS), Polysilizium, Nitrid oder Metall bestehen können. Diese Zwischenschichten können mittels bekannter Verbindungsverfahren, beispielsweise einem Waferbonden (Silicon Fusion Bonding), einem anodischen Bonden oder einem Kleben, miteinander verbunden werden. Alternativ kann eine größere Anzahl von Zwischenschichten zwischen den zu verbindenden Wafern verwendet werden, um damit die Erzeugung eines Hohlraums mit Bereichen einer variablen Höhe zu ermöglichen.

Die erfindungsgemäß erzeugten mikromechanischen Strukturen eignen sich insbesondere zum Einsatz in Drucksensoren, beispielsweise Absolutdrucksensoren oder Differenzdrucksensoren. Überdies können mittels des erfindungsgemäßen Verfahrens auch mikromechanische Strukturen erzeugt werden, die eine Mehrzahl von voneinander unabhängigen Membranbereichen aufweisen, um damit die Herstellung eines Drucksensorarrays zu ermöglichen. In gleicher Weise ist die vorliegende Erfindung jedoch auch einsetzbar, um mikromechanische Strukturen zur Verwendung in anderen mikro-elektromechanischen Bauelementen zu schaffen, beispielsweise elastische Platten von Ventilen oder Pumpen, schwingende Massen von Beschleunigungssensoren, bewegliche Finger oder Cantilever von mikromechanischen Relais und dergleichen.

Weiterbildungen der vorliegenden Anmeldung sind in den abhängigen Ansprüchen dargelegt.

Bevorzugte Ausführungsbeispiele der vorliegenden Erfindung werden nachfolgend bezugnehmend auf die beiliegenden zeichnungen näher erläutert. Es zeigen:
- Fig. 1a) bis 1c): schematische Querschnittansichten zur Erläuterung eines Ausführungsbeispiels des erfindungsgemäßen Verfahrens; und
- Fig. 2: eine Querschnittansicht eines elektrisch isolierten Schaltungselements in einem SOI-Substrat.

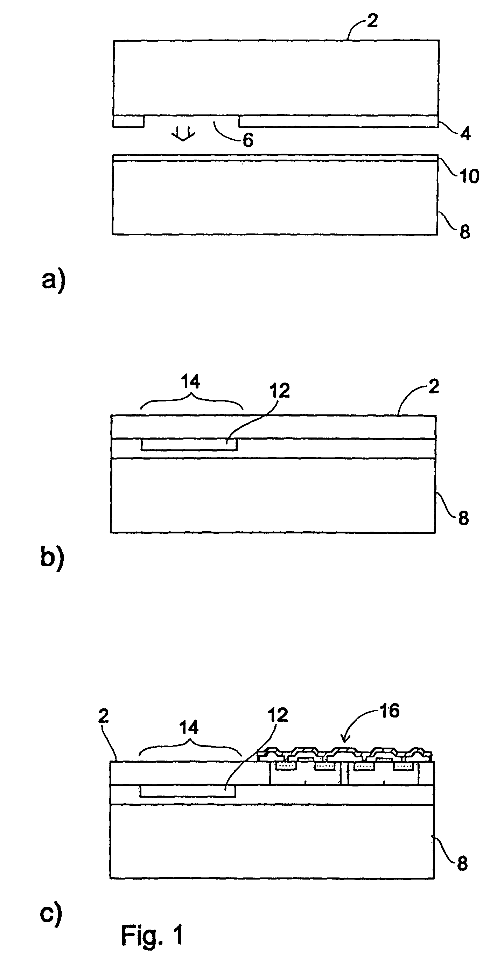

Bezugnehmend auf die Fig. 1a) bis 1c) wird nachfolgend ein bevorzugtes Ausführungsbeispiel des erfindungsgemäßen Verfahrens zum Herstellen eines mikromechanischen Elements erläutert, wobei das Verfahren zum Herstellen der mikromechanischen Struktur eines Drucksensors und nachfolgend zum Erzeugen einer integrierten Schaltung in dem Substrat, in dem die Membran des Drucksensors gebildet ist, dient.

Wie in Fig. 1a) gezeigt ist, wird zunächst eine auf einen ersten Halbleiterwafer 2 aufgebrachte Zwischenschicht 4 strukturiert, um eine Ausnehmung 6 in derselben zu bilden.

Der Halbleiterwafer 2 wird nachfolgend über die Zwischenschicht 4 mit einem zweiten Halbleiterwafer 8 verbunden, der bei dem dargestellten Ausführungsbeispiel ebenfalls mit einer Zwischenschicht 10 versehen ist. Durch das Verbinden der beiden Wafer 2 und 8 wird durch die Ausnehmung 6 ein hermetisch abgeschlossener Hohlraum 12 definiert, wie in Fig. 1b) zu sehen ist. Nach dem Verbinden der beiden Wafer 2 und 8 wird der erste Wafer 2 von der dem Wafer 8 abgewandten Hauptoberfläche desselben her gedünnt, um oberhalb des Hohlraums 12 eine membranartige Struktur 14 zu erzeugen. Dabei bleibt der in der Zwischenschicht 4 gebildete Hohlraum 12 hermetisch abgeschlossen.

Fig. 1b) zeigt die durch das erfindungsgemäße Verfahren hergestellte mikromechanische Struktur, wobei durch das Herstellungsverfahren derselben ermöglicht ist, daß in dem gedünnten Wafer 2, in dem die membranartige Struktur 14 gebildet ist, integrierte Schaltungsstrukturen 16 mittels herkömmlicher Standard-Halbleiterprozesse erzeugt werden, die zur Auswertung von durch die Membran 14 erzeugten Signalen dienen kann. Dadurch wird aus der mikromechanischen Struktur die in Fig. 1c) gezeigte mikro-elektromechanische Struktur, bei der in einem Halbleiterwafer 2 zum einen eine mikromechanische gefertigte Membran 14 als auch eine integrierte Schaltung 16, die beispielsweise mittels herkömmlicher CMOS-Techniken hergestellt ist, gebildet ist. Das erfindungsgemäße Verfahren zum Herstellen einer mikromechanischen Struktur ermöglicht diese Herstellung eines mikro-elektromechanischen Elements unter Verwendung herkömmlicher Standard-Halbleiterfertigungsprozesse, beispielsweise CMOS-Prozesse, da bis zur Vollendung der integrierten Schaltung der Hohlraum 12 stets hermetisch verschlossen bleibt. Somit ermöglicht die vorliegende Erfindung die kostengünstige Herstellung von mikro-elektromechanischen Elementen mit einer, verglichen mit herkömmlichen Verfahren, reduzierten Anzahl von Verfahrensschritten.

Bei dem erfindungsgemäßen Verfahren wird als Material für die Halbleiterwafer vorzugsweise Silizium verwendet, wobei die Zwischenschicht, bzw. die Zwischenschichten 4 und 10 in Fig. 1, vorzugsweise aus einem Oxid (thermisch oder TEOS), aus Polysilizium, aus einem Nitrid oder aus Metall besteht bzw. bestehen. Hierbei ist anzumerken, daß, obwohl bei dem oben beschriebenen Ausführungsbeispiel auf beiden Wafern eine Zwischenschicht angeordnet ist, bei dem erfindungsgemäßen Verfahren lediglich eine Zwischenschicht notwendig ist, in der die Ausnehmung strukturiert wird. Bei alternativen Ausführungsbeispielen kann eine Mehrzahl von Zwischenschichten zwischen den Wafern vorgesehen werden, so daß es möglich ist, durch unterschiedliche Strukturierung der einzelnen Schichten Hohlräume mit Bereichen unterschiedlicher Höhen zu erzeugen. Ferner wäre es alternativ zu dem in Fig. 1 gezeigten Verfahren möglich, auch in der auf das zweite Substrat 8 aufgebrachten Zwischenschicht 10 eine Strukturierung vorzusehen, so daß diese zusammen mit der in der Zwischenschicht 4 vorgesehenen Strukturierung nach dem Verbinden der Wafer den Hohlraum definiert. Dabei ist anzumerken, daß eine quasi unbegrenzte Möglichkeit der Strukturierung von Zwischenschichten zum Erzeugen unterschiedlicher Hohlräume existiert, solange die Hohlräume nach dem Verbinden der beiden Wafer hermetisch abgeschlossen sind. Die Strukturierung zur Erzeugung dieser Hohlräume kann durch bekannte Strukturierungsverfahren, beispielsweise Photolithographie, Naß- bzw. Trocken-Ätzen oder durch selektive Abscheidung erfolgen.

Die Verbindung der Wafer kann mittels bekannter Verbindungsverfahren erfolgen, wobei die beiden Wafer mit der oder den Verbindungsschichten aufeinandergelegt und mittels spezieller Prozesse miteinander verbunden werden, beispielsweise anodischen Bondverfahren, Klebeverfahren oder dem sogenannten Silicon Fusion Bonding. Nach diesem Verbinden entsteht aus den zunächst in der bzw. den Zwischenschichten strukturierten Ausnehmung, bzw. den Ausnehmungen, ein hermetisch abgeschlossener Hohlraum 12, wie er in Fig. 1b) gezeigt ist. Im Anschluß wird einer der beiden Halbleiterwafer auf eine vorgegebene Dicke gedünnt, so daß über dem Hohlraum eine membranartige Struktur entsteht. Dabei kann der zu dünnende Wafer vorzugsweise aus einem SOI-Material (Silicon on Isolator) bestehen, wodurch ein exaktes Dünnen erleichtert wird. Durch dieses Dünnen wird oberhalb der strukturierten Bereiche, d.h. über den Hohlräumen, eine sensorspezifische Zone bzw. eine Membran erzeugt, während die übrige Fläche des gedünnten Wafers für die Integration elektronischer Schaltungen dienen kann.

Die nach diesem Verfahren hergestellten mechanischen Strukturen, von denen beispielhaft eine in Fig. 1b) gezeigt ist, weisen jetzt noch eine nach oben geschlossene und planare Oberfläche und in der Tiefe einen oder mehrere hermetisch abgeschlossene Hohlräume auf. Damit kann der gedünnte Wafer mit den üblichen CMOS-Technologien bearbeitet werden.

Die Form der hermetisch abgeschlossenen Hohlräume ist im Grundriß beliebig, im einfachsten Fall rechteckig, vieleckig oder rund, und kann langgestreckte und gewundene Kanäle enthalten oder aus mehreren isolierten oder mit Kanälen verbundenen Strukturen bestehen. Die Höhe der Hohlräume ist durch die Dicke der strukturierten Schicht gegeben, wie in Fig. 1a) gezeigt ist, und damit im einfachsten Fall einheitlich. Durch eine mehrfache Strukturierung einer einzelnen Schicht oder durch eine Strukturierung mehrere Schichten kann jedoch, wie bereits oben erwähnt wurde, die Höhe der Hohlräume beliebig variiert werden, das heißt, es können Hohlräume mit Bereichen unterschiedlicher Höhe erzeugt werden.

Bei bevorzugten Ausführungsbeispielen des erfindungsgemäßen Verfahrens zum Erzeugen einer mikromechanischen Struktur wird der Schritt des Verbindens der beiden Wafer in einem Vakuum durchgeführt, so daß bei möglichen nachfolgenden Hochtemperaturprozessen kein Überdruck durch die thermische Expansion eines in den hermetisch abgeschlossen Hohlräumen enthaltenen Gases entsteht. Somit kann eine Beschädigung der über dem oder den Hohlräumen erzeugten membranartigen Strukturen vermieden werden, da beispielsweise einem Unterdruck von 1 bar im kalten Zustand, der beispielsweise bei einem Vakuum in dem Hohlraum vorliegt, leichter zu widerstehen ist, als einem Überdruck von 3 bar in einem Diffusionsofen bei beispielsweise 1100°C, wenn die Verbindung der Wafer nicht in einem Vakuum stattfindet. Je nach Anwendung der erfindungsgemäß erzeugten mikromechanischen Struktur ist es jedoch auch möglich, den Hohlraum mit einem speziellen Gas bei einem beliebigen Druck zu füllen.

Das erfindungsgemäße Verfahren zum Erzeugen einer mikromechanischen Struktur eignet sich insbesondere zur Herstellung mikromechanischer Teile unterschiedlicher Drucksensoren. Das Sensorsignal solcher Drucksensoren kann auf unterschiedliche Weise erzeugt werden, beispielsweise mittels integrierter piezoelektrischer Widerstände auf, in oder neben der erfindungsgemäß erzeugten Membran, oder mittels kapazitiver Meßverfahren durch das Anbringen einer beweglichen Elektrode auf der Membran und einer entsprechenden Gegenelektrode. Nach dem Fertigstellen der mikro-elektromechanischen Elemente unter Verwendung des erfindungsgemäßen Verfahrens zum Erzeugen einer mikromechanischen Struktur können die noch im Waferverbund befindlichen Elemente vereinzelt werden, um dadurch einzelne Sensorelemente zu erzeugen. Beispielsweise zeigt Fig. 1c) einen Absolutdrucksensor, bei dem der Hohlraum 12 hermetisch abgeschlossen bleibt, so daß durch den Sensor ein auf die Außenseite der Membran 14 wirkender Druck erfaßt werden kann.

Alternativ können durch das erfindungsgemäße Verfahren jedoch auch mikromechanische Strukturen für Differenzdrucksensoren oder Drucksensorarrays erzeugt werden.

Beispielsweise kann eine mikromechanische Struktur für einen Differenzdrucksensor erzeugt werden, indem der unter der membranartigen Struktur angeordnete Hohlraum mit einer Öffnung versehen wird, die den Hohlraum mit der Umwelt verbindet. Dadurch können auf den beiden Seiten der Membran unterschiedliche Drücke angelegt werden, so daß das Ausgangssignal des durch den Hohlraum und die Membran gebildeten Sensors die Differenz zwischen diesen Drücken anzeigt. Zum Herstellen einer mikromechanischen Struktur für einen solchen Differenzdrucksensor wird oder werden vor dem Verbinden der beiden Wafer in dem Wafer, der später nicht gedünnt wird, eine oder mehrere vertikale Öffnungen gebildet, die den Wafer nicht vollständig durchdringen. Diese Öffnungen können vorzugsweise geätzt werden. Nach dem Verbinden der Wafer ist diese Öffnung direkt mit dem Sensorhohlraum verbunden oder kann auch über einen Kanal mit dem Hohlraum verbunden sein. Nach der vollständigen Herstellung des mikro-elektromechanischen Elements, d.h. nach dem Integrieren der integrierten Schaltung in dem gedünnten Wafer, wird diese vergrabene Öffnung durch den nicht gedünnten Wafer geöffnet. Dieses Öffnen kann beispielsweise durch einen weiteren Ätzprozeß oder durch einen Dünnprozeß von der Rückseite her durchgeführt werden.

Alternativ kann ein Differenzdrucksensor realisiert werden, indem bei dem erfindungsgemäßen Verfahren zwei Hohlräume mit jeweils zugeordneten Membranen in der oder den Zwischenschichten strukturiert werden, die über einen oder mehrere vertikale oder laterale Kanäle miteinander verbunden sind. Die vertikalen Kanäle, die vorzugsweise eine geringere Höhe aufweisen als die Hohlräume, können durch unterschiedliches Strukturieren einer Zwischenschicht oder durch Strukturieren einer Mehrzahl von Zwischenschichten erzeugt werden. Einer der Hohlräume wird dann wiederum nach dem Erzeugen der integrierten Schaltung in dem Wafer nach außen geöffnet, um das Anlegen eines Druckes an die Unterseite der Membran zu ermöglichen, so daß ein Differenzdruck zwischen Unterseite und Oberseite der Membran erfaßt werden kann. Daneben ist es möglich, daß zwei oder mehr Sensoren, die jeweils aus Hohlraum und zugeordneter Membran bestehen, einen oder mehrere Differenzverstärker ansteuern.

Die Erzeugung einer Mehrzahl von Hohlräumen mit zugeordneten Membranen kann ferner genutzt werden, um ein Drucksensorarray, das eine hohe Auflösung bietet, zu realisieren. Dazu werden beispielsweise mehrere Hohlräume in einer Matrix nebeneinander in einer oder mehreren Zwischenschichten strukturiert, so daß sich nach dem Verbinden der Wafer ein Drucksensorarray ergibt. Nach dem Herstellen der mikromechanischen Struktur für das Drucksensorarray auf die erfindungsgemäße Art und Weise wird dann eine entsprechend angepaßte integrierte Schaltung in dem gedünnten Wafer erzeugt. Diese integrierte Schaltung kann beispielsweise angepaßt sein, um zur Erhöhung der Empfindlichkeit der Sensoren bzw. zur Erzielung eines höheren Sensorsignals die Sensorsignale zu addieren. Dabei wird bei dem für das System höchsten spezifizierten Druck beispielsweise nur das Signal eines Sensors auf der Matrix verarbeitet, während bei abnehmendem Druck das zu verarbeitende Signal durch die Addition der Signale mehrerer Sensoren aus der Matrix erhöht wird. Dabei kann es notwendig sein, daß jedes einzelne Sensorelement für sich kalibriert werden muß, um eine Fehleraddition zu vermeiden. Enthält die integrierte Schaltung einen Mikrocontroler, existiert die Möglichkeit, das System selbstkalibrierend aufzubauen. Beispielsweise kann von einem Mikrocontroler ein automatischer Nullabgleich gesteuert werden. Das Sensorsignal kann dann über eine integrierte Datenausgabekomponente, beispielsweise eine I²C-Schnittstelle, ausgelesen werden.

Mit dem erfindungsgemäßen Verfahren zum Erzeugen einer mikromechanischen Struktur ist es überdies auch möglich, hochtemperaturtaugliche integrierte Sensoren herzustellen. Eine solche Hochtemperaturfestigkeit kann bei nach den oben beschriebenen Verfahren hergestellten Differenzdrucksensoren und Drucksensorarrays beispielsweise durch designtechnische Maßnahmen erreicht werden, indem die sensitiven Elemente "gekapselt" werden, was beispielsweise durch ein Trench-Prozeßmodul oder durch Ausführung der Piezowiderstände in strukturiertem Polysilizium erreicht werden kann. Durch die Erweiterung des Standardprozesses mit einem Trenchmodul wird die Umhüllung einer elektronischen Schaltungskomponente oder eines mikromechanisch gebildeten Sensors mit einer isolierenden Schicht, z.B. einer Siliziumdioxid-Schicht, gewährleistet.

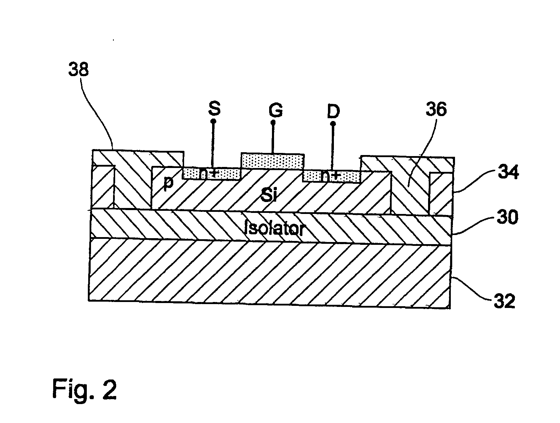

In gleicher Weise kann eine Hochtemperaturfestigkeit der integrierten Schaltung durch designtechnische Maßnahme erreicht werden. Die allseitige elektrische Isolation des Transistors reduziert das Volumen, aus dem thermisch generierte Minoritätsladungsträger in das aktive Gebiet diffundieren können und zu einem erhöhten Leckstrom führen. Diese Maßnahme ermöglicht also den Betrieb des Transistors auch bei hoher Temperatur. Beispielsweise ist in Fig. 2 ein SOI-Transistor im Querschnitt dargestellt, der durch ein "Trench-Prozeßmodul" gekapselt und somit elektrisch isoliert ist. Die elektrische Isolation des SOI-Transistors, der schematisch mit einem Source-Anschluß S, einem Gate-Anschluß G und einem Drain-Anschluß D in einer p-Typ Siliziumschicht gezeigt ist, wird zum einen durch die Isolatorschicht 30 des SOI-Substrats, das aus einer Trägerschicht 32, der Isolatorschicht 30 und einer auf der Isolatorschicht angeordneten Siliziumschicht 34 besteht, gebildet. Ferner ist der SOI-Transistor von Gräben 36, die als Trenches bezeichnet werden, umgeben, die den SOI-Transistor elektrisch isolieren. Auf der Oberfläche der Siliziumschicht 34 ist eine Passivierungsschicht 38 vorgesehen, die entweder zusammen mit dem Füllen der Gräben 36 oder danach aufgebracht wird.

Die vorliegende Erfindung ermöglicht somit Verfahren zum Erzeugen mikromechanischer Strukturen für mikro-elektromechanische Elemente, bei denen sämtliche Hohlräume der mikromechanischen Strukturen nach dem Erzeugen derselben hermetisch abgeschlossen sind, während eine nach oben geschlossen und planare Oberfläche geliefert wird, so daß die Wafer von oben unter Verwendung üblicher CMOS-Technologien bearbeitet werden können. Somit sind erfindungsgemäß Probleme, die bei herkömmlichen Verfahren durch das Reinigen von Waferoberflächen bzw. das Eindringen von Flüssigkeiten in Hohlräume und die Verschleppung von Partikeln und Kontaminationen bewirkt werden, beseitigt. Damit schafft die vorliegende Erfindung ein wenig aufwendiges Verfahren, das die Herstellung von mikromechanischen Elementen kostengünstig und mit hoher Ausbeute ermöglicht.

## Patentansprüche

1. Verfahren zum Erzeugen einer mikromechanischen Struktur für ein mikro-elektromechanisches Element, mit folgenden Schritten:
a) Strukturieren einer ersten Zwischenschicht (4), die auf eine erste Hauptoberfläche eines ersten Halbleiterwafers (2) aufgebracht ist, um eine Ausnehmung (6) zu erzeugen;
b) Verbinden des ersten Halbleiterwafers (2) über die erste Zwischenschicht (4) mit einem zweiten Halbleiterwafer (8), derart, daß durch die Ausnehmung (6) ein hermetisch abgeschlossener Hohlraum (12) definiert wird; und
c) Dünnen von einem der Wafer (2) von einer der ersten Zwischenschicht (4) abgewandten Oberfläche her, um eine membranartige Struktur (14) über dem Hohlraum (12) zu erzeugen,
gekenzeichnet durch den Schritt des
Vorsehens zumindest einer weiteren Zwischenschicht zwischen den beiden Halbleiterwafern (2, 8), die vor dem Verbinden der beiden Halbleiterwafer strukturiert wird, derart, daß die Strukturierung in der zumindest einen weiteren Zwischenschicht und die Ausnehmung in der ersten Zwischenschicht den Hohlraum definieren.

2. Verfahren nach Anspruch 1, bei dem auf die Hauptoberfläche des zweiten Halbleiterwafers (8), der über die Zwischenschicht (4) mit dem ersten Halbleiterwafer (2) verbunden wird, vor dem Verbinden eine Zwischenschicht (10) aufgebracht wird.

3. Verfahren nach Anspruch 2, bei dem die auf den zweiten Halbleiterwafer aufgebrachte Zwischenschicht strukturiert wird, derart, daß nach dem Verbinden die Strukturierung der zweiten Zwischenschicht und die Ausnehmung in der ersten Zwischenschicht den Hohlraum definieren.

4. Verfahren nach einem der Ansprüche 1 bis 3, bei dem die Zwischenschichten einen Hohlraum mit Bereichen variabler Höhe erzeugen.

5. Verfahren nach einem der Ansprüche 1 bis 4, bei dem der erste und der zweite Wafer (2, 8) aus Silizium bestehen.

6. Verfahren nach einem der Ansprüche 1 bis 5, bei dem die Zwischenschichten (4, 10) aus einem Oxid, aus Polysilizium, aus einem Nitrid oder aus Tetraethylorthosilikat bestehen.

7. Verfahren nach einem der Ansprüche 1 bis 6, bei dem die Zwischenschichten (4, 10) derart strukturiert werden, daß nach dem Verbinden der beiden Wafer mehrere, durch Kanäle verbundene, nach außen hermetisch abgeschlossene Hohlräume definiert sind.

8. Verfahren nach einem der Ansprüche 1 bis 7, bei dem nach dem Schritt c) eine integrierte Schaltung (16) in dem gedünnten Halbleiterwafer (2) erzeugt wird.

9. Verfahren nach Anspruch 8, bei dem die integrierte Schaltung unter Verwendung von Standard-Halbleiterprozessen erzeugt wird.

10. Verfahren nach einem der Ansprüche 1 bis 9, bei dem elektrisch isolierende Gräben (36) in dem gedünnten Halbleiterwafer gebildet werden, um elektrisch voneinander isolierte Bereiche in dem gedünnten Halbleiterwafer zu erzeugen.

11. Verfahren nach einem der Ansprüche 1 bis 10, bei dem das Verbinden im Schritt b) in einem Vakuum durchgeführt wird.

12. Verfahren nach einem der Ansprüche 1 bis 11, bei dem als erster und/oder zweiter Wafer ein SOI-Wafer verwendet wird.

13. Mikro-elektromechanisches Element, das nach einem Verfahren gemäß einem der Ansprüche 1 bis 12 hergestellt ist, mit folgenden Merkmalen:
einer ersten Halbleiterschicht (2);
zumindest einer Zwischenschicht (4), die auf eine erste Hauptoberfläche der ersten Halbleiterschicht (2) aufgebracht ist und eine Ausnehmung (6) aufweist;
einer zweiten gedünnten Halbleiterschicht (8), die über der Zwischenschicht (4) derart angeordnet ist, daß über der Ausnehmung (6) eine membranartige Struktur (14) gebildet ist; und
einer integrierten CMOS-Schaltung (16) in dem gedünnten Halbleiterwafer (2),
**gekennzeichnet durch**
zumindest eine weitere Zwischenschicht, die zwischen den beiden Halbleiterschichten (2, 8) angeordnet und strukturiert ist, derart, daß die Strukturierung in der zumindest einen weiteren Zwischenschicht und die Ausnehmung in der ersten Zwischenschicht der Hohlraum definieren.

## Claims

1. A method of producing a micromechanical structure for a micro-electromechanical element comprising the following steps:
a) structuring a first intermediate layer (4), which is applied to a first main surface of a first semiconductor wafer (2), so as to produce a recess (6);
b) connecting the first semiconductor wafer (2) via the first intermediate layer (4) to a second semiconductor wafer (8) in such a way that a hermetically sealed cavity (12) is defined by the recess (6); and
c) thinning one of the wafers (2) from a surface facing away from said first intermediate layer (4) so as to produce a diaphragm-like structure (14) on top of the cavity (12),
**characterized by** the step of
providing at least one further intermediate layer between the two semiconductor wafers (2, 8), which, prior to the connection of the two semiconductor wafers, is structured in such a way that the structure formed in said at least one further intermediate layer and the recess in said first intermediate layer define the cavity.

2. A method according to claim 1, wherein the main surface of the second semiconductor wafer (8), which is connected to the first semiconductor wafer (2) via the intermediate layer (4), has applied thereto an intermediate layer (10) prior to the connecting step.

3. A method according to claim 2, wherein the intermediate layer applied to the second semiconductor wafer is structured in such a way that, after the connecting step, the structure formed in the second intermediate layer and the recess in the first intermediate layer define the cavity.

4. A method according to one of the claims 1 to 3, wherein the intermediate layers produce a cavity with areas of variable height.

5. A method according to one of the claims 1 to 4, wherein the first and the second wafer (2, 8) consist of silicon.

6. A method according to one of the claims 1 to 5, wherein said intermediate layers (4, 10) consist of an oxide, of polysilicon, of a nitride or of tetraethylorthosilicate.

7. A method according to one of the claims 1 to 6, wherein said intermediate layers (4, 10) are structured in such a way that, after the connection of the two wafers, a plurality of cavities are defined, said cavities being interconnected by channels and hermetically sealed from their surroundings.

8. A method according to one of the claims 1 to 7, wherein, after step c), an integrated circuit (16) is produced in the thinned semiconductor wafer (2).

9. A method according to claim 8, wherein the integrated circuit is produced making use of standard semiconductor processes.

10. A method according to one of the claims 1 to 9, wherein electrically insulating trenches (36) are formed in the thinned semiconductor wafer so as to produce in said thinned semiconductor wafer areas which are electrically insulated from one another.

11. A method according to one of the claims 1 to 10, wherein the connection in step b) is carried out in a vacuum.

12. A method according to one of the claims 1 to 11, wherein an SOI wafer is used as a first and/or second wafer.

13. A micro-electromechanical element produced in accordance with a method according to one of claims 1 to 12, comprising:
a first semiconductor layer (2);
at least one intermediate layer (4) which is applied to a first main surface of the first semiconductor layer (2) and has a recess (6);
a second thinned semiconductor layer (8) which is arranged on top of said intermediate layer (4) in such a way that a diaphragm-like structure (14) is formed on top of the recess (6); and
an integrated CMOS circuit (16) in said thinned semiconductor wafer (2);
**characterized by**
at least one further intermediate layer which is arranged between the two semiconductor layers (2, 8) and is structured in such a way that the structure formed in said at least one further intermediate layer and the recess in said first intermediate layer define the cavity.

## Revendications

1. Procédé pour produire une structure micromécanique pour un élément micro-électromécanique, aux étapes suivantes consistant à :
a) structurer une première couche intermédiaire (4) appliquée sur une première surface principale d'une première plaquette à semi-conducteur (2), pour créer un évidement ;
b) assembler la première plaquette à semi-conducteur (2), par l'intermédiaire de la première couche intermédiaire (4), avec une seconde plaquette à semi-conducteur (8), de sorte qu'il soit défini, par l'évidemment (6), un espace vide (12) obturé hermétiquement ; et
c) amincir l'une des plaquettes (2) depuis une surface éloignée de la première couche intermédiaire (4), afin de créer une structure en forme de membrane (14) sur l'espace vide (12),
**caractérisé par** l'étape consistant à
prévoir entre les deux plaquettes à semi-conducteur (2, 8) au moins une autre couche intermédiaire structurée avant l'assemblage des deux plaquettes à semi-conducteur, de sorte que la structuration définisse l'espace vide dans l'au moins une autre couche intermédiaire et dans l'évidemment dans la première couche intermédiaire.

2. Procédé selon la revendication 1, dans lequel est appliquée, sur la surface principale de la seconde plaquette à semi-conducteur (8) assemblée, par l'intermédiaire de la couche intermédiaire (4), avec la première plaquette à semi-conducteur (2), avant l'assemblage, une couche intermédiaire (10).

3. Procédé selon la revendication 2, dans lequel la couche intermédiaire appliquée sur la seconde plaquette à semi-conducteur est structurée de telle sorte qu'après l'assemblage la structuration de la seconde couche intermédiaire et l'évidemment dans la première couche intermédiaire définissent l'espace creux.

4. Procédé selon l'une des revendications 1 à 3, dans lequel les couches intermédiaires créent un espace vide à zones de hauteur variable.

5. Procédé selon l'une des revendications 1 à 4, dans lequel la première et la seconde plaquette (2, 8) sont en silicium.

6. Procédé selon l'une des revendications 1 à 5, dans lequel les couches intermédiaires (4, 10) sont en oxyde, en polysilicium, en nitrure ou en orthosilicate de tétra-éthyle.

7. Procédé selon l'une des revendications 1 à 6, dans lequel les couches intermédiaires (4, 10) sont structurées de telle sorte qu'il est défini, après l'assemblage des deux plaquettes, plusieurs espaces vides, reliés par des canaux, obturés hermétiquement vers l'extérieur.

8. Procédé selon l'une des revendications 1 à 7, dans lequel il est généré, après l'étape c), un circuit intégré (16) dans la plaquette à semi-conducteur (2) amincie.

9. Procédé selon la revendication 8, dans lequel le circuit intégré est généré à l'aide de procédés à semi-conducteurs standards.

10. Procédé selon l'une des revendications 1 à 9, dans lequel sont formées des fosses électriquement isolantes (36) dans la plaquette à semi-conducteur amincie, afin de créer des zones isolées électriquement l'une de l'autre dans la plaquette à semi-conducteur amincie.

11. Procédé selon l'une des revendications 1 à 10, dans lequel l'assemblage à l'étape b) est effectué sous vide.

12. Procédé selon l'une des revendications 1 à 11, dans lequel il est utilisé, comme première et/ou comme seconde plaquette, une plaquette SOI.

13. Elément micro-électromécanique réalisé suivant un procédé selon l'une des revendications 1 à 12, aux caractéristiques suivantes :
une première couche à semi-conducteur (2) ;
au moins une couche intermédiaire (4) appliqué sur une première surface principale de la première plaquette à semi-conducteur (2) et présentant un évidemment (6);
une seconde plaquette à semi-conducteur amincie (8) disposée sur la couche intermédiaire (4) de telle sorte qu'il soit formé, par l'intermédiaire de l'évidemment (6), une structure en forme de membrane (14) ; et
un circuit CMOS intégré (16) dans la plaquette à semi-conducteur amincie (2),
**caractérisé par**
au moins une autre couche intermédiaire disposée entre les deux couches à semi-conducteur (2, 8) et structurée de telle sorte que la structuration dans l'au moins une autre couche intermédiaire et l'évidemment dans la première couche intermédiaire définisse l'espace vide.
